# EUROPÄISCHE PATENTANMELDUNG

(11) **EP 0 884 767 A2**
(43) Veröffentlichungstag der Anmeldung: **16.12.1998**
(21) Anmeldenummer: 98110817.8
(22) Anmeldetag: 12.06.1998
(51) Int. Cl.: H01L 21/20

(54) **Verfahren zur Epitaxie von Galliumnitrid auf Silizium-Substraten**

(30) Priorität: 13.06.1997 DE 19725900
(71) Anmelder: Strittmatter, André, 10409 Berlin (DE); Bimberg, Dieter, Prof. Dr., 14089 Berlin (DE); Krost, Alois, 13587 Berlin (DE)
(72) Erfinder: Strittmatter, André, 10409 Berlin (DE); Bimberg, Dieter, Prof. Dr., 14089 Berlin (DE); Krost, Alois, 13587 Berlin (DE)

(57) **Zusammenfassung**

Galliumnitrid (i.f. GaN) kann auf verschiedenen Substraten einkristallin abgeschieden werden. GaN-Substrate sind schwer in guter Kristallinität und gleichzeitig mit großer Fläche herzustellen und daher noch nicht verfügbar. Bevorzugtes Substratmaterial ist Saphir (Al₂O₃). Im Vergleich zum Silizium (i.f. Si) hat Saphir jedoch ein hohes Preis/Flächenverhältnis und kann nicht durch Dotierung elektrisch leitfähig gemacht werden.
Im neuen Verfahren erfolgt die Abscheidung von GaN auf Si durch Züchtung einer AlAs-Pufferschicht bei geringen Temperaturen. Als Pufferschichten werden in bisherigen Verfahren Galliumarsenid (i.f. GaAs), Aluminiumnitrid (i.f. AlN) und Galliumnitrid (i.f. GaN) verwendet. Der Temperaturbereich ist im Falle einer GaAs-Pufferschicht auf Grund der thermischen Zersetzung von GaAs bei Temperaturen über 800°C nach oben beschränkt, für AlN und GaN auf Grund der thermischen Stabilität des Ammoniaks nach unten auf Temperaturen um 600°C beschränkt. Diese Einschränkung zu überwinden erfordert bisher kompliziertere Verfahren (z.B. plasmaunterstützte Molekularstrahlepitaxie) oder alternative Stickstoffquellen, mit denen aber bisher nicht die qualitativ gleich gute Abscheidung von GaN gelingt. Auf(100)-Oberflächen des Siliziums kann GaN sowohl in kubischer als auch in hexagonaler Kristallform aufwachsen. Die Existenz von Mischphasen ist möglich. Die Unterdrückung einer einzelnen Phase gelingt bisher nur durch die Wahl spezieller Wachstumsparameter, wie z.B. Druck, Temperatur, Partialdrücke der einzelnen Komponenten. Zusätzlich können sich beim Wachstum von GaN auf der Si(100) Oberfläche Antiphasendomänen ausbilden, deren Grenzflächen die strukturelle und optische Qualität der GaN-Schicht durch nichtstrahlende Rekombination von freien Ladungsträgern verschlechtern.
Das neue Verfahren ermöglicht eine Erweiterung des Temperaturbereichs für die Züchtung der GaN-Schichten auf dem Si-Substrat, die Unterdrückung der Existenz von Mischphasen auf Si(100) Oberflächen ohne Rücksicht auf die Wahl der Prozeßparameter und das Wachstum von antiphasendomänen-freien GaN-Schichten auf Si(100) Oberflächen.

Das neue Verfahren beruht auf der Abscheidung einer AlAs-Zwischenschicht direkt auf das Si-Substrat. Auf die AlAs-Schicht wird die GaN-Schicht aufgewachsen. Dieses Verfahren erweitert den zugänglichen Temperaturbereich für die Pufferschicht in den wichtigen Bereich um 400°C und für die GaN Hauptschicht in den wichtigen Bereich über 950°C.
Wird das GaN Wachstum auf Si-Substraten vollzogen, deren Oberfläche in [100]-Richtung orientiert ist und mit V-förmigen Gräben mit geeignetem Abstand und geeigneter Breite präpariert wurde, so wird die Ausbildung der kubischen Phase des GaN unterdrückt.
Wird eine AlAs-Schicht bei Temperaturen um 400°C auf ein 2°-6° fehlorientiertes Si(100)-Substrat abgeschieden, so ist die AlAs Schicht frei von Antiphasengrenzflächen. Die nachfolgende Abscheidung von GaN führt dann ebenfalls zu antiphasenfreien Schichten.

Das Verfahren ermöglicht die Abscheidung von GaN auf Silizium-Substraten. Damit ist die Herstellung von einkristallinen GaN-Schichten mit derzeit größtmöglicher Oberfläche auf dem kostengünstigsten Substrat möglich. Durch die Dotierbarkeit von Si-Substraten ist die Herstellung von vertikalen p-n Strukturen möglich, eine für breitlückige Halbleiterbauelemente auf Grund der Selbstkompensation von Dotierstoffen und der Undotierbarkeit von anderen gebräuchlichen Substraten (wie z.B. Saphir und SiC) bisher schwierig herzustellende Struktur. Weiterer Vorteil der GaN-Herstellung auf Si-Substraten ist die mögliche Kopplung an die Sibasierte Mikroelektronik.

## Beschreibung

Die Erfindung befaßt sich mit der Abscheidung von Galliumnitrid (i.f. GaN) auf Silizium-Substraten (i.f. Si) als Grundlage für die Herstellung von Halbleiterbauelementen für die Hochleistungselektronik sowie für optoelektronische Anwendungen im kurzwelligen Spektralbereich.
Die Abscheidung von GaN erfordert ein Subtratmaterial, dessen kristalline Eigenschaften idealerweise mit den Kristalleigenschaften von GaN übereinstimmen sollten. Neben der Übereinstimmung in den Kristallparametern (z.B. Gitterkonstante, thermischer Ausdehnungskoeffizient) stellt sich die Frage nach der verfügbaren Fläche, auf der GaN abgeschieden werden kann. Die Abscheidung von GaN auf GaN-Substraten ist durch die Schwierigkeit der Herstellung großflächiger und qualitativ guter Substrate limitiert. Infolgedessen ergibt sich die Suche nach geeigneten Fremdsubstraten, deren Materialeigenschaften und Größe eine Anwendung für die Abscheidung von GaN nahelegen.
Im Mittelpunkt steht bisher Saphir als Substrat. Daneben werden andere Materialien wie SiC, ZnO u.a. eingesetzt. Auf diesen Substraten gelingt die Abscheidung von GaN in einer Qualität, die die erfolgreiche Realisierung von Halbleiterbauelementen, wie z.B. im blauen Spektralbereich emittierende Leuchtdioden und Laserdioden, ermöglicht. Jedoch sind diese Substrate in ihren Kristalleigenschaften stark verschieden von GaN, elektrisch nicht leitfähig und zusätzlich in ihrer Größe technisch z. Zt, auf etwa 1-2 Zoll Durchmesser beschränkt.
Silizium-Einkristalle sind die derzeit größtflächigsten Substrate (z. Zt. bis zu 10 Zoll Durchmesser), die für die Abscheidung von dünnen Halbleiterschichten zur Verfügung stehen. Zudem liegen die Herstellungskosten weit unter denen für alle anderen möglichen Substrate. Diese Eigenschaften, die mögliche Dotierbarkeit und die auf Si-Substraten existierende, weit fortgeschrittene Mikroelektronik machen es wünschenswert, GaN in hoher Qualität auf Si abzuscheiden. Problematisch sind jedoch die zu GaN ebenfalls unterschiedlichen Materialparameter. Die Differenz der Gitterkonstanten ist so groß, daß es nicht gelingt auch nur atomar dünne Schichten ohne Ausbildung von Versetzungen auf das Substrat abzuscheiden. Durch das Aufwachsen dicker Schichten >1µm ist es möglich, die Dichte der Versetzungen zu verringern, da sich aufeinandertreffende Versetzungen gegenseitig annihilieren können. Jedoch erzwingt der Unterschied in den thermischen Ausdehnungskoeffizienten eine zusätzliche Verspannung der GaN-Schicht während des Abkühlens von der Prozeßtemperatur auf Raumtemperatur. Dies führt zu einer zusätzlichen Ausbildung von Versetzungen, zur Bildung von Mikrorissen oder sogar zum Ablösen der GaN-Schicht vom Si-Substrat. Weiterhin stellt man fest, daß bei Temperaturen, die für das Wachstum von GaN-Schichten unter Verwendung von Ammoniak mit ausreichender Wachstumsrate notwendig sind (950-1050°C), keine homogene Bekeimung des Substrats erfolgt, wodurch ein planares Wachstum induziert werden würde, sondern sich dreidimensionale Wachstumsinseln ausbilden, die zu polykristallinen Schichten führen. Stand der Technik ist es daher, zunächst mit einer Niedertemperatur-Zwischenschicht eine homogene Bedeckung des Si-Substrats zu erreichen und anschließend die GaN-Schicht abzuscheiden. Bekannte Zwischenschichten sind GaN, AlN und GaAs mit denen die nachfolgende Abscheidung von GaN auf Si gelingt [J.W. Yang et al. in Appl. Phys. Lett. 69, S. 3566 (1996); P. Kung et al. in Appl. Phys. Lett. **66**, S. 2958 (1995); T.S. Cheng in Appl. Phys. Lett. 66, S. 1509 (1995)].
Die Verwendung von GaAs als Zwischenschicht führt zu einer oberen Beschränkung der Prozeßtemperaturen für die Abscheidung von GaN, da sich GaAs bei Temperaturen größer als 800°C teilweise zersetzt. Die entstehenden Gase verschlechtern die Morphologie der darüberliegenden GaN-Schicht bzw. führen zum Einbau von As-Atomen in die GaN-Schicht [J.N. Kuznia et al. in Appl. Phys. Lett. **65**, 2407 (1994)]. Die Prozeßtemperaturen müssen daher im Falle einer GaAs-Zwischenschicht unter 800°C gehalten werden. Bei diesen Temperaturen findet jedoch keine effiziente Zerlegung von Ammoniak, der derzeit gebräuchlichsten und kostengünstigsten Stickstoff-Quelle für die Abscheidung von GaN aus der Gasphase, statt. In diesem Falle müssen aufwendige und teure Verfahren, wie *Elektronen-Zyklotron-Resonanz-Molekularstrahlepitaxie* angewendet werden, um bei geringen Temperaturen in einem Plasma molekularen Stickstoff in atomaren Stickstoff zu zerlegen.
Eine spezielle GaN oder AlN-Zwischenschicht begünstigt die nachfolgende Abscheidung von GaN. Das Wachstum aus der Gasphase kann jedoch nicht bei Temperaturen unter 600°C erfolgen, wegen der notwendigen Zerlegung des Ammoniaks, so daß hierfür wieder auf das *Elektronen-Zyklotron-Resonanz - Molekularstrahlepitaxie*-Verfahren zurückgegriffen werden muß. Eine solche Niedertemperaturabscheidung gerade der ersten Monolagen auf das Si-Substrat ist jedoch für das Wachstum von polaren Kristallen (GaN auf unpolaren Substraten (Si) aus mehreren Gründen erwünscht. Erstens zeigt es sich, daß bei niedrigen Wachstumstemperaturen eine homogenere Bekeimung des Substrats erreicht werden kann, da bei solchen Temperaturen ein extremer Kristallisationsdruck erzeugt werden kann. Für Ashaltige Verbindungen wurde gezeigt, daß sich die qualitativ besten Schichten wachsen lassen, wenn die Pufferschicht bei Temperaturen um 400°C gezüchtet wurde [F. Heinrichsdorff, Diplomarbeit, TU Berlin, 1992]. Zum zweiten existiert für Si (100)-Oberflächen bei gegebener Fehlorientierung eine kritische Temperatur, über der es zur Ausbildung von Antiphasen-Grenzflächen kommt, weil die Si-Oberfläche dann monoatomare Stufen aufweist [M. Grundmann, Dissertation, TU Berlin, 1991, S. 61ff]. Mit zunehmender Fehlorientierung des Si-Substrates tritt jedoch eine zusätzliche Verschlechterung der Oberflächenmorphologie auf. Deshalb ist man bestrebt, das Optimum zwischen Fehlorientierung des Substrates und Wachstumstemperatur einzuhalten. Gute Resultate erzielt man, wenn Fehlorientierungen des Si-Substrates von 2°-6° in [110]-Richtung mit Wachstumstemperaturen um 400°C kombiniert werden.
Bekannt ist, daß auf Kristallen mit kubischer Struktur der Einheitszelle, GaN mit unterschiedlicher Kristallstruktur aufwachsen kann in Abhängigkeit von der Orientierung der Substratoberfläche. Auf (100)-Oberflächen wird die Ausbildung der metastabilen kubischen Phase des GaN beobachtet, teilweise in Koexistenz mit der stabilen hexagonalen Phase [T. Lei et al. in Appl. Phys. Lett. **59**, S. 944 (1991); T.S. Cheng in Appl. Phys. Lett. 66, S, 1509 (1995)]. Die in [111]-Richtung orientierten Oberflächen kubischer Kristalle dagegen erlauben nur die Ausbildung der stabilen hexagonalen Phase des GaN. Generell ist zumindest die Koexistenz der kubischen neben der hexagonalen Phase für technologisch relevante Aspekte von Bauelementen unerwünscht.

Das im Patentanspruch 1 angegebene Verfahren soll den zugänglichen Temperaturbereich für die Abscheidung der ersten Monolagen auf das Si-Substrat in den Niedertemperaturbereich um 400°C erweitern, während eine Prozeßtemperatur für die Abscheidung der GaN-Hauptschicht im oberen Temperaturbereich von ungefähr 1000°C ermöglicht werden soll.
Dies wird durch das im Patentanspruch 1 angegebene Verfahren erreicht. Die angegebenen Unteransprüche 2 und 3 entsprechen unterschiedlichen Ausführungsmöglichkeiten der Erfindung. Unteranspruch 4 zum Patentanspruch 1 bezieht sich auf eine spezielle Substratpräparation, mit der es möglich ist, die Ausbildung der kubischen Phase des GaN und die Ausbildung von Antiphasendomänen auf Si(100)-Oberflächen zu unterdrücken. Unteranspruch 5 zum Patentanspruch 1 beinhaltet die Unterdrückung von Antiphasendomänen in der GaN-Schicht auf Si(100) Oberflächen durch die Präparation von Doppelstufen auf der Oberfläche.

Der Vorteil des Verfahrens besteht darin, daß eine AlAs-Zwischenschicht zu ähnlichen Bedingungen wie eine GaAs-Schicht auf Si abgeschieden werden kann. Das heißt, die Abscheidung der ersten Monolagen auf Si kann bei Temperaturen um 400°C geschehen, da sich sowohl Aluminium als auch Arsen bei diesen Temperaturen im atomaren Zustand erzeugen lassen. Im Gegensatz zu einer GaAs-Schicht sind auch Prozeßtemperaturen um 1000°C für die Abscheidung der GaN-Schicht möglich, da AlAs thermisch wesentlicher stabiler ist als GaAs. Dies folgt aus der höheren Bildungsenthalpie von AlAs (-116,315 kJ/mol) gegenüber GaAs (-74,056 kJ/mol)[O. Knacke et al, Thermochemical properties of inorganic substances, vol. 1, 2nd ed., Springer, 1991].
Somit sind entscheidend verbesserte Voraussetzungen für die kostengünstige Abscheidung von GaN-Schichten auf großflächigen Si-Substraten gegeben.
Unteranspruch 2 gibt ein auf Patentanspruch 1 beruhendes Verfahren an, wie durch Umwandlung von GaAs in GaN in einer an atomaren Stickstoff reichen Atmosphäre bei substantiell geringeren Temperaturen (700-800°C) eine GaN-Schicht auf Si erzeugt werden kann, auf der nachfolgend eine GaN-Schicht bei hohen Temperaturen (ca. 1000°C) aufgewachsen werden kann. Dadurch wird eine einfache Möglichkeit geschaffen, eine Bekeimung der Fläche mit GaN als Ausgangspunkt für das Wachstum der GaN Hauptschicht zu erzeugen.
Der in Punkt 3 geltend gemachte Unteranspruch beinhaltet die Möglichkeit der gezielten Umwandlung einer dünnen AlAs-Schicht in eine AlN-Schicht durch eine Temperung in einer an atomaren Stickstoff reichen Umgebung. Durch dieses Verfahren wird ebenfalls eine Bekeimung der Epitaxiefläche mit AlN erreicht, und somit eine für das GaN-Wachstum geeignete Substratoberfläche geschaffen.
Der Unteranspruch 4 zum Patentanspruch 1 beinhaltet eine spezielle Präparation der Substratoberfläche von (100) orientierten Si-Kristallen für die Epitaxie von GaN. Durch die angegebene Präparation der Substratoberfläche werden bei geeignetem Verhältnis von Grabenbreite zu Grabenabstand ausschließlich die Grabenseitenflächen (die in [111] bzw. [1-11] Richtung orientiert sind) im Anfangsstadium des Wachstums bekeimt, so daß die Ausbildung der kubischen Phase des GaN auch auf (100) Oberflächen unterdrückt werden kann. Der Unteranspruch 5 zum Patentanspruch 1 beinhaltet eine spezielle Substratpräparation von Si(100) Oberflächen für die Epitaxie von GaN. Durch die angegebene Präparation werden auf der Oberfläche atomare Doppelstufen ausgebildet, die in Verbindung mit der Niedertemperaturabscheidung der AlAs-Pufferschicht die Ausbildung von Antiphasengrenzflächen in der GaN-Schicht verhindert.

Nachfolgend wird ein Prozeßablauf beschrieben, wie er zur Herstellung von GaN auf Si-Substraten durchgeführt werden kann.
Der Prozeßablauf bezieht sich hierbei auf die Verwendung einer Anlage zur metallorganischen Gasphasenepitaxie. Solche Anlagen sind kommerziell erhältlich. Ihre spezielle Konstruktion ist nicht entscheidend für die Durchführung der Epitaxie. Für die Epitaxie werden Metallorganika der Elemente der III. Hauptgruppe (Aluminium, Gallium) mit Hydridverbindungen der Elemente der V. Hauptgruppe (Arsen, Stickstoff) vermittels eines Trägergases von den Quellen zum Substrat transportiert, das sich auf einer wachstumsspezifischen Temperatur befindet. Die Ausgangsverbindungen zerlegen sich auf Grund der erhöhten Temperatur in ihre Bestandteile über dem Substrat und werden zum Substrat durch den sich ausbildenden Konzentrationsgradienten transportiert. Auf der Substratoberfläche werden die Atome gebunden. Für die Durchführung des Verfahrens nach Patentanspruch 1 werden im folgenden Beispiel benötigt:
- Substrat:: Si-Einkristall beliebig orientiert und dotiert, mindestens einseitig poliert, beliebige Größe
- Ausgangssubstanzen:: Arsin (AsH₃), Ammoniak (NH₃)
Trimethylgallium TMGa ((CH₃)₃Ga),
Trimethylaluminium TMAl ((CH₃)₃Al)
Wasserstoff (H₂)
- MOCVD-Anlage ausgerüstet mit:: - getrennten Linien für die Hydride und Metallorganika
- sogenannten Bubblern in denen sich die Metallorganika befinden
- Temperaturbädern für die Bubbler zur Stabilisierung des Dampfdrucks der Metallorganika
- Massenflußreglern für die Regelung der Flüsse der Quellverbindungen zum Reaktor
- Reaktor für Temperaturen bis 1000°C an dessen Eingang die Gase gemischt werden
- Suszeptor, der zur Aufnahme des Si-Substrates geeignet ist
- regelbare Heizquelle, die im Suszeptor Temperaturen bis 1000°C erzeugen kann
- Pumpe, die zur Erzeugung eines kontinuierlichen Gasstromes über das Substrat und zur Einstellung des Reaktordrucks genutzt werden kann
- Gaswaschsystem zur Entsorgung der Prozeßgase

Die Vorbehandlung der Si-Substrate erfolgt standardmäßig nach folgendem Plan:
1.5 Minuten Baden in 40°C warmen Propanol unter Ultraschall
2. Spülen mit deionisierten Wasser
3. 1 Minute Ätzen mit konzentrierter (96%) Schwefelsäure
4. Spülen mit deionisierten Wasser
5. 30 Sekunden Ätzen mit 5%iger Flußsäure
6. Spülen mit deioniserten Wasser
7. Zweimalige Wiederholung der Schritte 3.-6.
8. Trockenschleudern des Substrates auf geeigneter Schleuder

Diese Substratpräparation führt zu einer Sauerstoff-freien, Wasserstoff-passivierten Oberfläche.

Nach dem Einbau des Substrates in den Reaktor erfolgt die Prozeßsteuerung wie folgt:
0. Einleitung von H₂ in den Reaktor und als Trägergas in die Gasleitungen
1. Einstellung der Flüsse für die einzelnen Verbindungen und des Gesamtflusses Gesamtfluß: 5,52 l/min AsH₃: 200 ml/min. NH₃: 2 l/min, TMGa: 5 ml/min, TMAl: 40 ml/min
2. Absenkung des Reaktordrucks auf 100 mbar
3. Einleitung von AsH₃ in den Reaktor
4. Aufheizen des Substrates auf 425°C
5. Einleitung von TMAl in den Reaktor für 30 Sekunden Wachstum von AlAs
6. Aufheizen des Substrates auf 700°C
7. Einleitung von TMAl in den Reaktor für 1 Minute: Wachstum von AlAs
8. Aufheizen des Substrates auf 950°C
9. Abschalten des AsH₃-Zuflusses und Einleitung von NH₃ in den Reaktor
10. nach 1 Minute Einleitung von TMGa in den Reaktor für 15 Minuten: Wachstum von GaN
11. Abschaltung der Heizung und Abkühlen des Substrates auf Raumtemperatur unter Zufuhr von NH₃

Die Schritte 0.-11. sollen im folgenden näher erläutert werden. Das Durchspülen aller Leitungen mit dem sogenannten Trägergas in Schritt 0. sorgt für einen gleichmäßigen und kontinuierlichen Transport der Ausgangssubstanzen von den Quellen zum Reaktor. Als Trägergas dient Wasserstoff oder eine andere gasförmige Substanz, die sich gegenüber den Reaktionspartnern inert verhält (z.B. Stickstoff). Im 1. Schritt werden geeignete Ausgangsflüsse für die Quellen eingestellt, wobei zu beachten ist, daß das Trägergas die sogenannten Bubbler mit den Metallorganika durchspült und auf Grund des herrschenden Dampfdrucks der Verbindung einen gewissen Anteil der Substanz mitführt. Die Flußangabe ist also nicht als Absolutangabe für die Metallorganika zu verstehen, sondern als Angabe für die Trägergasmenge, die in den Bubbler fließt. Die Größe des Gesamtflußes ist in Abhängigkeit der Reaktorgeometrien und Leitungsquerschnitte so zu wählen, daß eine laminare Gasströmung über das Substrat gewährleistet ist. Der angegebene Reaktordruck wurde als geeignet für die Schichtenabscheidung ermittelt, Abweichungen von diesem Wert sind zulässig. Bevor der 1. Aufheizvorgang beginnt (Schritt 4.), wird AsH₃ in den Reaktor geleitet. Ab einer gewissen Temperatur erfolgt eine Substitution der obersten Monolage von Si-Atomen durch Arsen-Atome, die Oberfläche befindet sich dann im Gleichgewicht mit der Gasphase. Ist die Temperatur für die Abscheidung der AlAs-Pufferschicht erreicht, erfolgt die zusätzliche Einleitung von TMAl in den Reaktor. Über dem Substrat zerlegen sich die Ausgangssubstanzen TMAl und AsH₃, so daß sich die Gasphase über dem Substrat nicht mehr im Gleichgewicht mit der Substratoberfläche befindet. Für die Dauer der Einleitung von TMAl in den Reaktor wird deshalb AlAs auf der Substratoberfläche abgeschieden. Nach 30 Sekunden wird der Wachstumsvorgang unterbrochen und in Schritt 6 das Substrat auf 700°C aufgeheizt, um nachfolgend eine AlAs-Schicht höherer Qualität abzuscheiden (7. Schritt). Anschließend wird unter AsH₃-Zufuhr auf die Wachstumstemperatur der GaN-Schicht aufgeheizt (950°C). In Schritt 9 wird der Zufluß von AsH₃ gestoppt und dafür NH₃ in den Reaktor geleitet und die AlAs-Oberfläche für 1 Minute der NH₃-Atmosphäre ausgesetzt. Hierbei kommt es zur teilweisen Umwandlung von AlAs in AlN. Im Anschluß (10. Schritt) erfolgt dann das Wachstum von GaN durch zusätzliche Einleitung von TMGa in den Reaktor. Der 11. Schritt beinhaltet das Abkühlen des Substrats auf Raumtemperatur, wobei die Oberfläche durch eine NH₃-Atmosphäre gegen Verdampfen stabilisiert wird.

Diese Erfindung ist nicht auf das beschriebene Ausführungsbeispiel beschränkt, sondern sinngemäß übertragbar. Insbesondere ist die Erfindung nicht beschränkt auf die angegebenen speziellen Temperaturen, Drücke, Flüsse und Wachstumszeiten. Sie ist sinngemäß übertragbar auch auf andere Epitaxieverfahren, wie z. B. Molekularstrahlepitaxie, Metallorganische Molekularstrahlepitaxie, Gasquellen-Molekularstrahlepitaxie.

## Patentansprüche

1. Verfahren zur Epitaxie von Galliumnitrid auf Silizium-Substraten
dadurch gekennzeichnet, daß zwischen Silizium-Substrat und Galliumnitrid-Schicht eine Aluminiumarsenid-Schicht aufgebracht wird

2. Verfahren nach Anspruch 1 dadurch gekennzeichnet, daß auf die Aluminiumarsenid-Schicht eine GaAs-Schicht abgeschieden wird und diese in Galliumnitrid umgewandelt wird, bevor die Abscheidung von Galliumnitrid vollzogen wird.

3. Verfahren nach Anspruch 1 und 2 dadurch gekennzeichnet, daß die Aluminiumarsenid-Schicht in einer stickstoffreichen Umgebung in eine Aluminiumnitrid-Schicht teilweise oder ganz umgewandelt wird.

4. Verfahren nach Anspruch 1 bis 3 dadurch gekennzeichnet, daß das Silizium-Substrat mit seiner Oberflächennormalen in die kristallographische [100]-Richtung (oder äquivalente Richtungen) orientiert ist und dessen Oberfläche durch Gräben mit V-förmigem Profil strukturiert ist, deren Seitenflächen in zur [111]-Richtung (oder äquivalenten Richtungen) orientiert sind.

5. Verfahren nach Anspruch 1 bis 3 dadurch gekennzeichnet, daß das Silizium-Substrat mit seiner Oberflächennormalen in einem Winkel von 2° bis 6° zur kristallographischen [100]-Richtung (oder äquivalenten Richtungen) orientiert ist.
